# EUROPÄISCHE PATENTSCHRIFT

(11) **EP 1 547 454 B1**
(45) Veröffentlichungstag und Bekanntmachung des Hinweises auf die Patenterteilung: **01.03.2006**
(21) Anmeldenummer: 03750360.4
(22) Anmeldetag: 18.09.2003
(51) Int. Cl.: H05K 7/14

(54) **ELEKTRONISCHES GERÄT MIT SCHWIMMEND GELAGERTEM SCHALTUNGSTRÄGER**
ELECTRONIC APPLIANCE COMPRISING A FLOATING CIRCUIT CARRIER
APPAREIL ELECTRONIQUE POURVU D'UN SUPPORT DE CIRCUIT A LOGEMENT FLOTTANT

(30) Priorität: 02.10.2002 DE 10246095
(43) Veröffentlichungstag der Anmeldung: 29.06.2005
(73) Patentinhaber: SIEMENS AKTIENGESELLSCHAFT, 80333 München (DE)
(72) Erfinder: LEHMEIER, Annemarie, 92289 Ursensollen (DE); APFELBACHER, Walter, 92271 Freihung (DE); SEITZ, Johann, 92224 Amberg (DE)
(86) Internationale Anmeldenummer: PCT/DE2003/003105
(87) Internationale Veröffentlichungsnummer: WO 2004/032589

(56) Entgegenhaltungen:
- EP-A- 1 014 771
- WO-A-01/87029
- US-A- 4 811 168

## Beschreibung

Die Erfindung bezieht sich auf ein elektronisches Gerät, insbesondere Schaltgerät, mit einem Gehäuse und einem darin gehaltenen elektronischen Schaltungsträger.

Der in einem derartigen Gerät vorgesehene Schaltungsträger ist meistens in Form einer so genannten Flachbaugruppe ausgebildet. Darunter wird eine Leiterplatte verstanden, die mit Elementen einer elektronischen Schaltung bestückt ist. Diese Elemente umfassen insbesondere Anzeigeelemente (z.B. Leuchtdioden), Einstellelemente (z.B. Potentiometer und Schalter) sowie Anschlusselemente wie z.B. Stiftleisten oder Klemmen. Die Flachbaugruppe ist zudem häufig mit im Gehäuse angeordneten separaten Elementen, wie z.B. Anschlussklemmen und weiteren elektronischen Komponenten elektrisch leitend verbunden.

Zur Senkung der Produktionskosten ist eine einfache, insbesondere leicht automatisierbare Montage des Schaltungsträgers im Gehäuse wünschenswert. Andererseits ist der Schaltungsträger exakt und möglichst spielfrei im Gehäuse zu positionieren, um sicherzustellen, dass die Einstell- und Anschlusselemente von der Gehäuseaußenseite gut zugänglich sind oder dass die Anzeigeelemente durch entsprechende Gehäuseöffnungen oder Gehäusefenster gut sichtbar sind.

Bei herkömmlichen Geräten dieser Art ist der Schaltungsträger häufig in eine starre Gehäuseführung eingeschoben, in welcher er nach Zusammenbau des Gehäuses fixiert ist. Mit einer starren Führung ist jedoch eine spielfreie Halterung des Schaltungsträgers technisch nicht oder nur schwer realisierbar.

Durch die DE 42 43 656 A1 ist eine Trägermaterial-Befestigungsvorrichtung bekannt, bei der das Trägermaterial durch zur Montagevorrichtung seitliches Wegdrücken eines Halters mit nachgiebigen Teilen in seine Montagendlage bringbar und in dieser durch Rückschnappen des Halters zwischen diesem und einer Chassis-Stützklaue fixierbar ist; das Trägermaterial kann vom Chassis dadurch wieder getrennt werden, dass auf den Halter ein seitlicher Druck ausgeübt wird.

Durch die DE 196 30 173 A1 ist ein Leistungsmodul mit einem Modulplättchen bekannt, das zu seiner mechanischen Fixierung durch ein Gehäuse gegen eine Isolierkeramikfläche gedrückt und zu seiner elektrischen Kontaktierung mit Leiterplatten von in dem Gehäuse gelagerten gesonderten Drehkontaktfedern beaufschlagt wird.

Der Erfindung liegt die Aufgabe zugrunde, ein einfach zu montierendes elektronisches Gerät anzugeben, bei dem der Schaltungsträger besonders präzise im Gehäuse positioniert ist.

Diese Aufgabe wird erfindungsgemäß gelöst durch die Merkmale des Anspruchs 1. Danach ist der Schaltungsträger eines elektronischen Geräts auch bei geschlossenem Gehäuse in diesem verschiebbar geführt und wird von mindestens einem Federelement, das gleichzeitig als elektrisches Kontaktelement dient, gegen einen Gehäuseanschlag beaufschlagt. Der Schaltungsträger ist somit im Gehäuse schwimmend gelagert und der erfindungsgemäße Federkontakt dient nicht nur der schwimmenden Lagerung des Schaltungsträgers sondern stellt gleichzeitig auch die elektrische Verbindung zwischen dem Schaltungsträger und einem separaten Element, z.B. einer Kontaktklemme, her. Eine aufwändige Verlötung des Schaltungsträgers bei der Montage ist somit überflüssig. Bevorzugt ist dieser oder jeder Federkontakt als federnder Stiftkontakt ausgebildet.

Die schwimmende Lagerung des Schaltungsträgers ermöglicht eine besonders einfache Montage des Geräts, zumal der Schaltungsträger zunächst drucklos in die Gehäuseführung einsetzbar ist. Die Positionierung und Fixierung des Schaltungsträgers erfolgt automatisch beim Zusammensetzen des Gehäuses durch das dabei in Vorspannung gebrachte Federelement. Bei geschlossenem Gehäuse beaufschlagt das Federelement den Schaltungsträger derart, dass dieser gegen einen Gehäuseanschlag gedrückt wird, der den Schaltungsträger in der gewünschten Position zentriert. Der Schaltungsträger ist auf diese Weise zwischen dem Gehäuseanschlag und dem Federelement im Wesentlichen spielfrei und positionsgenau gelagert.

Vorzugsweise ist der Schaltungsträger eine Flachbaugruppe, d.h. insbesondere plattenartig ausgebildet. Der Schaltungsträger ist dabei zweckmäßigerweise senkrecht zur Plattenebene im Gehäuse verschiebbar geführt, so dass ein besonders einfaches Einsetzen des Schaltungsträgers in die Gehäuseführung ermöglicht ist.

In einer vorteilhaften Ausgestaltung der Erfindung ist das Einsetzen des Schaltungsträgers weiterhin dadurch erleichtert, dass der Schaltungsträger mit einer Führungskontur in Form zweier, an gegenüberliegenden Seitenrändern angeordneten Einkerbungen versehen ist, die mit korrespondierenden, in den Gehäuseinnenraum hineinragenden Gehäusevorsprüngen zusammenwirken. Diese Gehäusevorsprünge sind vorzugsweise durch im Gehäuse vorgesehene Schraubenkanäle realisiert. Die besagten Schraubenkanäle durchsetzen das Gehäuse und dienen zur Aufnahme jeweils einer Befestigungsschraube, mittels welcher das Gerät auf einem Träger anschraubbar ist.

Nachfolgend wird ein Ausführungsbeispiel der Erfindung anhand einer Zeichnung näher erläutert. Dabei zeigen:
- FIG 1: in einer Explosionsdarstellung von schräg oben ein elektronisches Gerät mit einem als Flachbaugruppe ausgeführten Schaltungsträger und
- FIG 2: das elektronische Gerät gemäß FIG 1 in einer Explosionsdarstellung von schräg unten.

Einander entsprechende Teile sind in den Figuren mit den gleichen Bezugszeichen versehen.

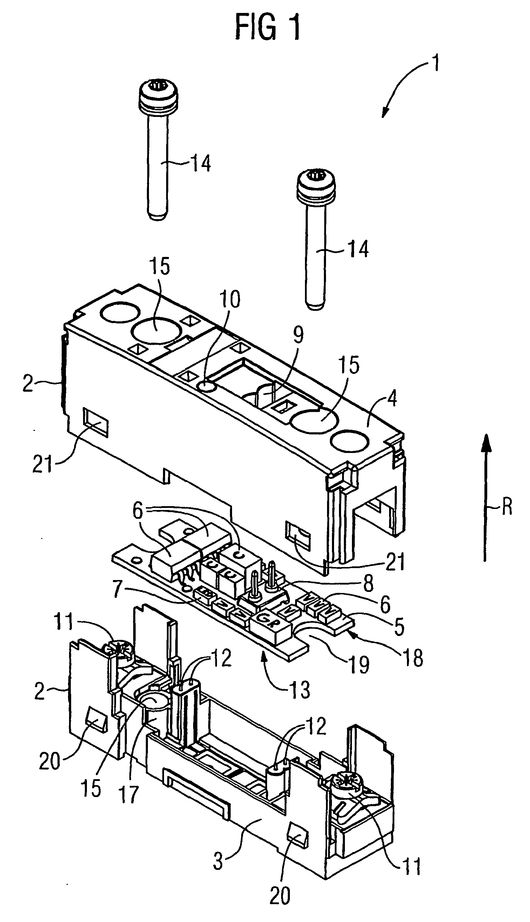

Bei dem in FIG 1 in Explosionsdarstellung gezeigten elektronischen Gerät 1 handelt es sich beispielsweise um ein Schaltgerät. Das Gerät 1 umfasst ein isolierendes Gehäuse 2 mit einem wannenartigen Gehäuseboden 3 und einem auf diesen aufsetzbaren Gehäusedeckel 4. Das Gerät 1 umfasst weiterhin eine in das Gehäuse 2 einsetzbare Flachbaugruppe 5, d.h. einen plattenartigen Schaltungsträger, der mit Elementen einer elektronischen Schaltung, insbesondere elektronischen Bauteilen 6 bestückt ist. Die Bauteile 6 umfassen insbesondere eine Leuchtdiode (LED) 7. Weiterhin ist die Flachbaugruppe 5 mit einer Stiftleiste 8 versehen. Die Stiftleiste 8 korrespondiert dabei mit einer buchsenartigen Gehäuseöffnung 9 im Gehäusedeckel 4, durch welche die Stiftleiste 8 von der Gehäuseaußenseite her kontaktierbar ist. Die Leuchtdiode 7 korrespondiert wiederum mit einem im Gehäusedeckel 4 angeordneten Gehäusefenster 10. Für eine einwandfreie Funktion des Geräts 1 ist eine präzise Positionierung der Flachbaugruppe 5 bezüglich des Gehäusedeckels 4 erforderlich, um sicherzustellen, dass einerseits die Leuchtdiode 7 im Bereich des Gehäusefensters 10 angeordnet ist, und andererseits die Stiftleiste 8 bezüglich der Gehäuseöffnung 9 zentriert ist.

Die Flachbaugruppe 5 ist weiterhin mit zwei im Gehäuseboden 3 angeordneten Kontaktklemmen 11 und weiteren, nicht näher dargestellten elektronischen Komponenten verbunden. Der Kontakt zwischen diesen separaten Elementen und der Flachbaugruppe 5 wird über Stiftkontakte 12 hergestellt, welche vom Gehäuseboden 3 in den Gehäuseinnenraum hineinragen und die Flachbaugruppe 5 an deren Unterseite 13 kontaktieren.

Das Gerät 1 ist weiterhin mit zwei Befestigungsschrauben 14 versehen, die zur Befestigung des Geräts 1 an einem nicht dargestellten Träger, beispielsweise innerhalb eines Schaltschrankes, dienen. Jede Befestigungsschraube 14 ist dazu in einen Schraubenkanal 15 einsetzbar, der sowohl den Gehäusedeckel 4 als auch den Gehäuseboden 3 durchsetzt.

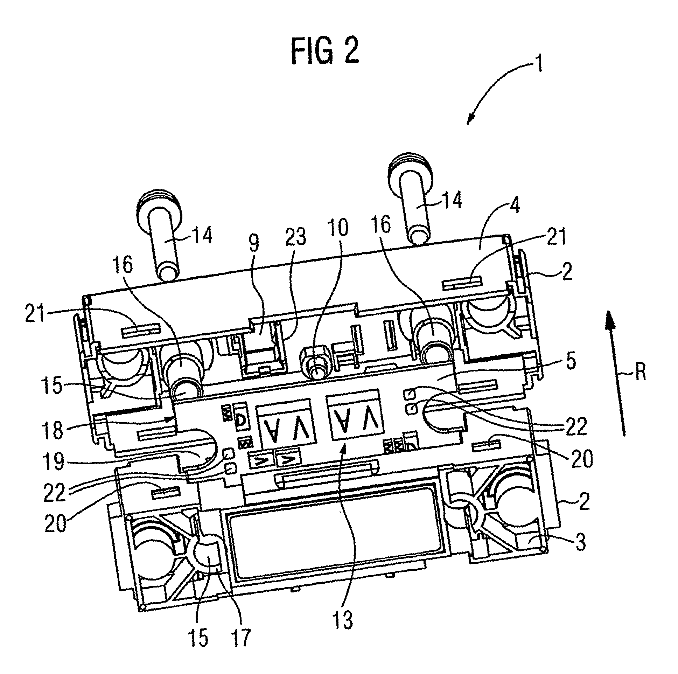

Wie insbesondere aus einer Zusammenschau der FIG 1 und 2 ersichtlich ist, ist jeder Schraubenkanal 15 durch einen vom Gehäusedeckel 4 in den Gehäuseinnenraum hineinragenden, etwa hohlzylindrischen Gehäusevorsprung 16 gebildet, der bei zusammengefügtem Gehäuse 2 auf Stoß an einer entsprechenden Bohrung 17 des Gehäusebodens 3 anliegt.

Bei der Montage des Geräts 1 wird zunächst die Flachbaugruppe 5 derart in den Gehäusedeckel 4 eingesetzt, dass sie zwischen den beiden Gehäusevorsprüngen 16 einliegt. Jedes Längsende 18 der Flachbaugruppe 5 ist dazu mit einer als Führungskontur und Einführhilfe dienenden Einkerbung 19 versehen, deren jede einen korrespondierenden Vorsprung 16 mit Spiel formschlüssig aufnimmt. Mit anderen Worten umgreift der Rand der Einkerbung 19 bei eingesetzter Flachbaugruppe 5 locker den Umfang des Vorsprungs 16 von drei Seiten. Die zwischen den beiden Vorsprüngen 16 einliegende Flachbaugruppe ist somit bezüglich einer zu ihrer Plattenebene parallelen Richtung vorfixiert. Die Flachbaugruppe 5 ist jedoch senkrecht zu ihrer Plattenebene gegenüber dem Gehäusedeckel 4 verschiebbar.

In einem folgenden Montageschritt wird der Gehäuseboden 3 in Montagerichtung R in den Gehäusedeckel 4 eingeschoben, bis am Gehäuseboden 3 angebrachte Rastnasen 20 in entsprechenden Aufnahmen 21 des Gehäusedeckels 4 verrasten und der Gehäuseboden 3 dadurch am Gehäusedeckel 4 unverlierbar fixiert ist. Bei diesem Montageschritt wird jeder Stiftkontakt 12 gegen eine korrespondierende, an der Unterseite 13 der Flachbaugruppe 5 angeordnete Kontaktfläche 22 gedrückt. Aufgrund ihrer federnden Wirkung geben die Kontaktstifte 12 dabei etwas entgegen der Montagerichtung R nach und werden dabei gegen die Flachbaugruppe 5 vorgespannt. Bei geschlossenem Gehäuse 2 ist somit einerseits der elektrische Kontakt zwischen den Kontaktklemmen 11 und der Flachbaugruppe 5 über die Kontaktstifte 12 und die Kontaktflächen 22 hergestellt.

Auch bei geschlossenem Gehäuse 2 ist die Flachbaugruppe 5 zum anderen gegen die Vorspannung der Kontaktstifte 12 verschiebbar und somit schwimmend gelagert.

Durch die Vorspannung der Kontaktstifte 12 wird die Flachbaugruppe 5 gegen den Gehäusedeckel 4 beaufschlagt, wobei die Stiftleiste 8 gegen den Innenrand 23 der Gehäuseöffnung 9 angedrückt wird. Durch die Anlage der Stiftleiste 8 an der Kontur des als Gehäuseanschlag dienenden Innenrands 23 wird die Flachbaugruppe 5 bei der Montage des Gehäuses 2 automatisch punktgenau und in guter Näherung spielfrei fixiert.

## Patentansprüche

1. Elektronisches Gerät (1), insbesondere Schaltgerät, mit einem Gehäuse (2) und einem darin von einem Federelement im Sinne einer schwimmenden Lagerung verschiebbar geführten und gegen einen Gehäuseanschlag (23) beaufschlagten Schaltungsträger (5), wobei als Federelement ein Federkontakt (12) vorgesehen ist, der mit jeweils einer Kontaktfläche (22) des Schaltungsträgers (5) zu dessen elektrischer Kontaktierung zusammenwirkt, **dadurch gekennzeichnet, dass** der Schaltungsträger (5) plattenartig ausgebildet und bezüglich dessen Plattenebene senkrecht verschiebbar geführt ist, wobei der Schaltungsträger (5) als Führungsmittel an zwei gegenüberliegenden Seitenrändern (18) jeweils eine Einkerbung (19) aufweist, in der ein korrespondierender, in das Gehäuse (2) hineinragender Gehäusevorsprung (16) formschlüssig einliegt.

2. Elektronisches Gerät nach Anspruch 1, **dadurch gekennzeichnet , dass** der Federkontakt ein federnder Stiftkontakt (12) ist.

3. Elektronisches Gerät nach Anspruch 1 oder 2, **dadurch gekennzeichnet, dass** der oder jeder Gehäusevorsprung (16) ein zur Aufnahme einer Befestigungsschraube (14) vorgesehener Schraubenkanal (15) ist.

4. Elektronisches Gerät nach zumindest einem der Ansprüche 1 bis 3, **dadurch gekennzeichnet, dass** das mit dem Schaltungsträger (5) durch das Federelement gegen den Gehäuseanschlag (23) beaufschlagbare Gehäuse (2) durch einen in Achse der Beaufschlagung des Federelements aufsetzbaren Gehäusedeckel (4) verschließbar ist.

5. Elektronisches Gerät nach Anspruch 4, **dadurch gekennzeichnet, dass** eine mit dem Schaltungsträger (5) versehene, von außerhalb des Gehäuses (2) kontaktierbare Stiftleiste (8) in einer korrespondierenden buchsenartigen Gehäuseöffnung (9) in dem aufgesetzten Gehäusedeckel (4) durch den Andruck des Federelementes an den Schaltungsträger (5) fixierbar ist.

## Claims

1. Electronic appliance (1), in particular switchgear appliance, having a housing (2) and a circuit carrier (5), which is guided therein in a displaceable manner in the sense of a floating mounting by a spring element and is acted upon against a housing stop (23), a spring contact (12) being provided as the spring element, which spring contact interacts with a respective contact area (22) of the circuit carrier (5) for the purpose of making electrical contact with the latter, **characterized in that** the circuit carrier (5) is formed in a boardlike manner and is guided in a displaceable manner perpendicularly with regard to the board plane thereof, the circuit carrier (5) having a respective indentation (19) at two opposite side edges (18) as guide means, a corresponding housing projection (16) that protrudes into the housing (2) being accommodated in said indentation in a positively locking manner.

2. Electronic appliance according to Claim 1, **characterized in that** the spring contact is a resilient pin contact (12).

3. Electronic appliance according to Claim 1 or 2, **characterized in that** the or each housing projection (16) is a screw channel (15) provided for receiving a fastening screw (14).

4. Electronic appliance according to at least one of Claims 1 to 3, **characterized in that** the housing (2) that can be acted on with the circuit carrier (5) against the housing stop (23) by the spring element can be closed by a housing cover (4) that can be emplaced on the axis along which the spring element acts.

5. Electronic appliance according to Claim 4, **characterized in that** a male strip connector (8) that is provided with the circuit carrier (5) and can be contact-connected outside the housing (2) can be fixed in a corresponding socketlike housing opening (9) in the emplaced housing cover (4) by the pressure of the spring element onto the circuit carrier (5).

## Revendications

1. Appareil (1) électronique, notamment appareil de coupure, comprenant un boîtier (2) et un support (5) de circuit qui est guidé avec possibilité de déplacement par un élément de ressort au sens d'un montage flottant et qui est repoussé sur une butée (23) du boîtier, dans lequel il est prévu comme élément à ressort un contact (12) à ressort qui coopère avec, respectivement, une surface (22) de contact du support (5) de circuit pour sa mise en contact électrique, **caractérisé en ce que** le support (5) de circuit est du type à plaque et est guidé de manière à pouvoir se déplacer perpendiculairement à son plan de plaque, le support (5) de circuit ayant comme moyen de guidage sur deux bords (18) latéraux opposés, respectivement, une encoche (19) dans laquelle vient, à complémentarité de forme, une saillie (16) correspondante du boîtier pénétrant dans le boîtier (2).

2. Appareil électronique suivant la revendication 1, **caractérisé en ce que** le contact à ressort est un contact (12) élastique à broche.

3. Appareil électronique suivant la revendication 1 ou 2, **caractérisé en ce que** la saillie ou chaque saillie (16) du boîtier est un canal (15) de vissage prévu pour la réception d'une vis (14) de fixation.

4. Appareil électronique suivant au moins l'une des revendications 1 à 3, **caractérisé en ce que** le boîtier (2) pouvant être repoussé avec le support (5) de circuit par l'élément à ressort sur la butée (23) de boîtier peut être fermé par un couvercle (4) de boîtier pouvant être mis dans l'axe de la course de l'élément à ressort.

5. Appareil électronique suivant la revendication 4, **caractérisé en ce qu'**une embase mâle (8) munie du support (5) de circuit et pouvant être mise en contact de l'extérieur du boîtier (2) peut être immobilisée dans une ouverture (9) du boîtier correspondante de type à douille ménagée dans le couvercle (4) du boîtier qui est posé en appliquant l'élément à ressort sur le support (5) de circuit.
